# EUROPÄISCHE PATENTSCHRIFT

(11) **EP 1 352 701 B1**
(45) Veröffentlichungstag und Bekanntmachung des Hinweises auf die Patenterteilung: **12.12.2007**
(21) Anmeldenummer: 02008416.6
(22) Anmeldetag: 12.04.2002
(51) Int. Cl.: B23K 20/00, H01L 21/00, B26D 7/26

(54) **Bonddraht-Schneidvorrichtung**
Cutting device for wire bonder
Dispositif de coupe pour une unité de connexion de fils

(43) Veröffentlichungstag der Anmeldung: 15.10.2003
(73) Patentinhaber: F & K Delvotek Bondtechnik, 85521 Ottobrunn (DE)
(72) Erfinder: Farassat, Farhad, Dr., 82024 Taufkirchen (DE)
(74) Vertreter: Heinze, Ekkehard

(56) Entgegenhaltungen:
- DE-U- 9 321 269
- US-A- 5 365 657
- US-B1- 6 206 275

## Beschreibung

Die Erfindung betrifft eine Bonddraht-Schneidvorrichtung nach dem Oberbegriff des Anspruchs 1. Sie betrifft außerdem die Verwendung einer solchen Vorrichtung bei einem Drahtbonder, speziell einem sogenannten Dickdrahtbonder.

Schneidvorrichtungen dieser Art sind bei Drahtbondern seit längerem bekannt.

Drahtbonder sind in einer Vielzahl von Ausführungen im praktischen Einsatz, bei denen zur Erzeugung eines Bondkontaktes ein Bonddraht mittels eines Bondwerkzeuges (Wedge = Stempel oder Keil o.ä.) auf ein Substrat gepresst und durch dem Bondwerkzeug aufgeprägte Ultraschallschwingungen fest stoffschlüssig mit dem Substrat verbunden wird. Das Bondwerkzeug ist zu diesem Zweck an einem senkrecht zur Substrat- und damit Bondkontaktoberfläche auf und ab bewegbaren Bondkopf angeordnet. Zur Realisierung der erforderlichen Beweglichkeit des Bondkopfes sind geeignete Antriebs- und Antriebssteuermittel vorhanden; ebenso ist das Substrat in einer im wesentlichen zur Bewegungsrichtung des Bondkopfes senkrechten Ebene verfahrbar, um an verschiedenen Stellen Bondkontakte herstellen zu können.

Gegenüber früheren Bondvorrichtungen, die üblicherweise eine Mehrzahl von Antrieben für den Bondkopf selbst und das Bondwerkzeug sowie gegebenenfalls für Klemmeinrichtungen zum Erfassen des Bonddrahtes und für ein Messer zum Abtrennen des Bonddrahtes aufwiesen, hat die Drahtbonder-Konstruktion gemäß der DE-U-93 21 269 der Anmelderin wesentliche Vereinfachungen und eine erhöhte Funktionssicherheit und Maßhaltigkeit der bearbeiteten Bauelemente erbracht.

Jedoch hat sich die Lebensdauer des Messers zum Abschneiden des Bonddrahtes nach Herstellung der Bondverbindung als noch nicht zufriedenstellend erwiesen, und Verbesserungsbedarf wurde auch hinsichtlich der Qualität der den Bonddrahtüberstand abtrennenden Schnitte erkennbar.

Aus der US-A-5,365,657 ist eine Bonddraht-Schneidvorrichtung der in Rede stehenden Art mit nachgiebiger Messerhalterung bekannt.

Der Erfindung liegt die Aufgabe der Bereitstellung einer verbesserten Bonddraht-Schneidvorrichtung zugrunde, welche insbesondere qualitativ verbesserte Schnitte bei erhöhter Lebensdauer des Messers liefert.

Diese Aufgabe wird durch eine Bonddraht-Schneidvorrichtung mit den Merkmalen des Anspruchs 1 gelöst.

Die Erfindung schließt den grundlegenden Gedanken einer nachgiebigen bzw. gedämpften Halterung des Messers zum Abtrennen des Bonddrahtes ein. Mit dieser neuartigen Halterung soll eine Begrenzung der beim Auftreffen des Messers auf den Bondkontakt - insbesondere auf das Substrat nach Durchtrennen des Bonddrahtes - auftretenden Kraft-Spitzenwerte erreicht werden.

Diese Spitzenkraftbegrenzung ergibt zum einen sauberere Schnitte und erhöht zum anderen die Lebensdauer des Messers, nach bisher vorliegenden Erfahrungen des Erfinders auf das Zwei- bis Dreifache. Zudem wird die Bruchgefahr wesentlich verringert; Messerbrüche treten mit der neuen Halterung praktisch nicht mehr auf.

Erfindunggemäß ist das Messer an einer Halterung mit vorbestimmter Elastizität befestigt, die eine geringfügige Nachgiebigkeit in der Messer-Bewegungsrichtung (also im wesentlichen auch der Bewegungsrichtung des Bondwerkzeuges, die nachfolgend auch als z-Richtung bezeichnet wird) sichert. Eine elastische Nachgiebigkeit im Bereich von wenigen Hundertstel Millimeter reicht für den angestrebten Zweck völlig aus, die genaue Dimensionierung der Halterung ist selbstverständlich auf die Konstruktion und den Anwendungszweck des Drahtbonders abzustimmen.

In einer nicht anspruchsgemäßen Ausführung ist diese Halterung biegeelastisch ausgeführt, und zwar als biegeelastische Verbindung des Messers mit einem die senkrechte Bewegungskomponente übertragenden Kraftübertragungselement. In einer besonders einfachen Ausführung handelt es sich hierbei um eine Blattfederkonstruktion, in die insbesondere mindestens ein Elastomerblock zur zusätzlichen Dämpfung eingefügt ist. Eine solche Halterung ähnelt in gewisser Weise der Halterung des Bondwerkzeuges am Ultraschallerreger (Transducer). Diese Halterung stellt aus derzeitiger Sicht des Erfinders die bevorzugte Variante dar.

Erfindungsgemäß ist eine druckelastische Lagerung vorgesehen, die ein formelastisches oder kompressibles Elastomerelement in Längsachsenrichtung von Messer und Kraftübertragungselement umfasst.

In einer weiteren bevorzugten Ausführung der Erfindung ist eine Möglichkeit zur Einstellung der Nachgiebigkeit bzw. des Dämpfungsverhaltens der Messerhalterung und/oder ein Anschlag zur Begrenzung der Auslenkung des Messers aufgrund seiner Nachgiebigkeit vorgesehen. Besonders bevorzugt ist hierbei ein verstellbarer Anschlag, der zugleich die Auslenkungsbegrenzung erbringt und dessen Verstellung eine Variation der durch die Konstruktion der Messerhalterung weitgehend vorbestimmten Elastizitäts- bzw. Dämpfungseigenschaften ermöglicht.

Der Antrieb des nachgiebig gehalterten Messers kann durch eine separate Antriebseinheit erfolgen - kostengünstiger und einfacher ist jedoch das Vorsehen eines gemeinsamen Antriebes für Bondwerkzeug und Messer, d.h. für alle Bewegungen der relevanten Werkzeuge des Bondkopfes in Richtung der Z-Achse.

Die Erfindung zielt insbesondere auch auf die Verwendung der vorgeschlagenen Bonddraht-Schneidvorrichtung bei einem Drahtbonder ab, wobei das Messer mit vorbestimmter Nachgiebigkeit an dessen Bondkopf angebracht ist.

Vorteile und Zweckmäßigkeiten der Erfindung ergeben sich im übrigen aus den Unteransprüchen sowie der nachfolgenden Beschreibung eines bevorzugten Ausführungsbeispiels anhand der Figuren. Von diesen zeigen:
- Fig. 1 bis 7: einzelne Schritte des Ablaufes eines typischen Bondvorganges, einschließlich des Abtrennens eines überstehenden Abschnittes des Bonddrahtes,
- Fig. 8: eine Prinzipskizze einer an einem Bondkopf angebrachten, nicht anspruchsgemäßen BonddrahtSchneidvorrichtung,
- Fig. 9: eine Prinzipskizze einer an einem Bondkopf angebrachten Bonddraht-Schneidvorrichtung gemäß einer Ausführungsform der Erfindung und
- Fig. 10: eine Prinzipskizze einer an einem Bondkopf angebrachten, nicht anspruchsgemäßen Bonddraht-Schneidevorrichtung.

Ein Dickdrahtbonder mit fortgeschrittener Konstruktion wie er in der oben bereits erwähnten DE-U-93 21 269 genauer beschrieben ist, arbeitet grundsätzlich wie folgt:

Zunächst wird der Bondkopf in Bondrichtung gedreht und ausgehend von dieser Startposition unter Mitnahme eines Drahtes hin zu einer ersten Kontaktfläche auf Bondhöhe abgesenkt. Sodann erfolgt ein sogenannter "touch-down" eines am Bondkopf angeordneten Stempels, und zwar unter Ultraschallerregung desselben. Hiermit einhergehend wird ein erster Bond ausgebildet. Anschließend wird der Bondkopf längs einer vorgegebenen Raumkurve unter Ausbildung eines sogenannten "loop" zu einer zweiten Kontaktfläche bewegt.

Es erfolgt ein erneuter "touch-down" des am Bondkopf angeordneten Stempels unter Ultraschallerzeugung desselben, so dass ein zweiter Bond ausgebildet wird. Danach wird der Bondkopf wieder etwas hoch und seitlich zurück, d.h. entgegen der Drahtzuführungsrichtung bewegt unter Ausbildung einer sogenannten "tail-length". Ist das Drahtmesser in Drahtzuführungsrichtung gesehen hinter dem Stempel angeordnet, erfolgt eine Zurückbewegung des Bondkopfes unter Ausbildung der sogenannten "tail-length" so weit, bis das Messer außerhalb der Bondstelle liegt. Dann wird der Bondkopf wieder abgesenkt, bis das Drahtmesser wirksam ist unter Ausbildung eines Trennschnitts, wobei der Draht nur teilweise durchgetrennt wird. Danach fährt der Bondkopf wieder hoch und zurück, um den Draht an der Schnitt- bzw. Trennstelle abzureißen.

Wenn das Messer zwischen Stempel und Drahtführungsröhrchen liegt, wird die erste "tail-length"-Bewegung des Bondkopfes entbehrlich, wodurch sich die Arbeitsgeschwindigkeit erhöhen lässt. Mit der ersten Konstruktion, bei der das Messer hinter dem Stempel angeordnet ist, lassen sich jedoch besser bzw. präziser "loops" kleiner Abmessung herstellen; dann kann eine etwas geringere Arbeitsgeschwindigkeit in Kauf genommen werden.

Die beschriebene Zurückbewegung des Bondkopfes lässt sich auch durch entsprechende Vorwärtsbewegung der Unterlage ersetzen. Insofern kommt es nur auf die Relativbewegung zwischen Bondkopf und Unterlage samt Kontaktflächen an.

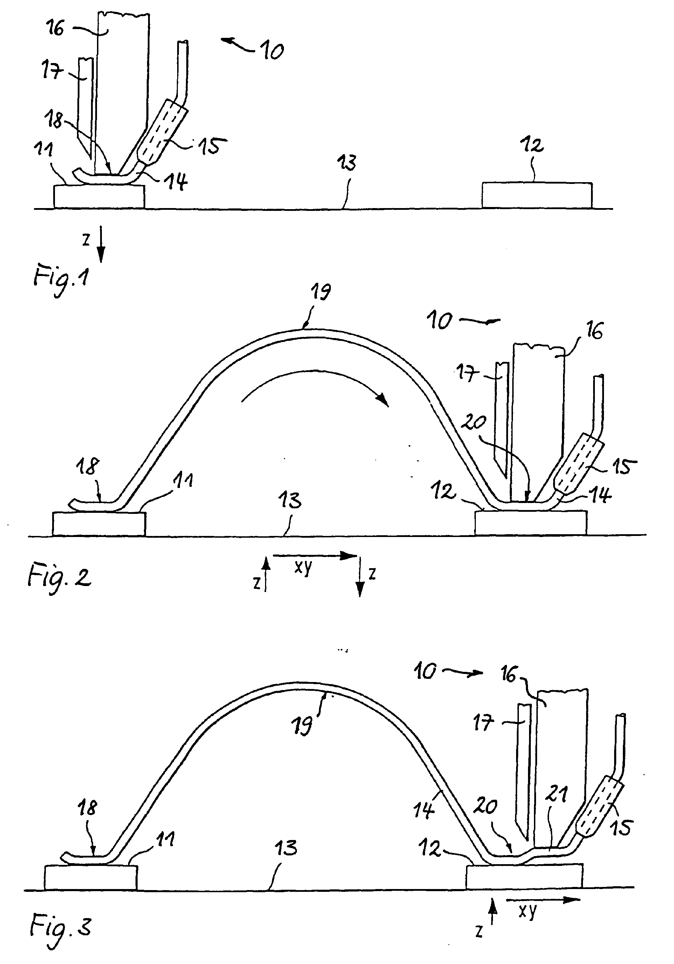

In den Figuren 1 bis 7 sind als wesentliche Teile eines (nicht vollständig dargestellten) Drahtbonders 10 zur Herstellung einer Drahtbondverbindung zwischen zwei Kontaktflächen 11 und 12 auf einem Bauelement 13 mittels eines Bonddrahtes 14 ein Drahtführungsröhrchen 15, ein Stempel (Wedge) 16 und ein Messer 17 gezeigt.

Bei dem in Fig. 1 gezeigten Zustand ist der Stempel 16 auf die erste Kontaktfläche 11 auf dem Bauelement 13 (auf einer nicht näher dargestellten Unterlage) mit dem Bonddraht 14 dazwischen abgesenkt. Der Bonddraht 14 wird auf eine hier nicht näher dargestellte Weise von dem Bondkopf mitgenommen bzw. durch das Drahtführungsröhrchen 15 nachgeschoben. Fig. 1 zeigt den sogenannten "touch-down" des Stempels 16 unter gleichzeitiger Ultraschallerregung durch einen (nicht dargestellten) Transducer zur Ausbildung eines ersten Bonds 18 auf der Kontaktfläche 11. Der Stempel 16 ragt in diesem Zustand in Z-Richtung nach unten über das Messer 17 und das Drahtführungsröhrchen 15 hinaus; das Messer wirkt also noch nicht auf den Bonddraht ein.

Gemäß Fig. 2 wird der Bondkopf (und mit ihm der Stempel 16, das Drahtführungsröhrchen 15 und das Messer 17) unter Ausbildung einer Bonddrahtschlaufe (Loop) 19 in einer zusammengesetzten Bewegungsfolge anheben/laterales verschieben/absenken gemäß den unterhalb der Bauelementoberfläche 13 dargestellten z- und xy-Pfeilen zu der zweiten Kontaktfläche 12 bewegt. Dort erfolgt ein erneuter "touch-down" unter Ausbildung eines zweiten Bonds 20. Wiederum steht der Stempel 16 über das freie Ende des Messers 17 und das untere Ende des Drahtführungsröhrchens 15 vor, so dass nur er den Bonddraht berührt und unter Ultraschallerregung die zweite Bondverbindung erzeugt.

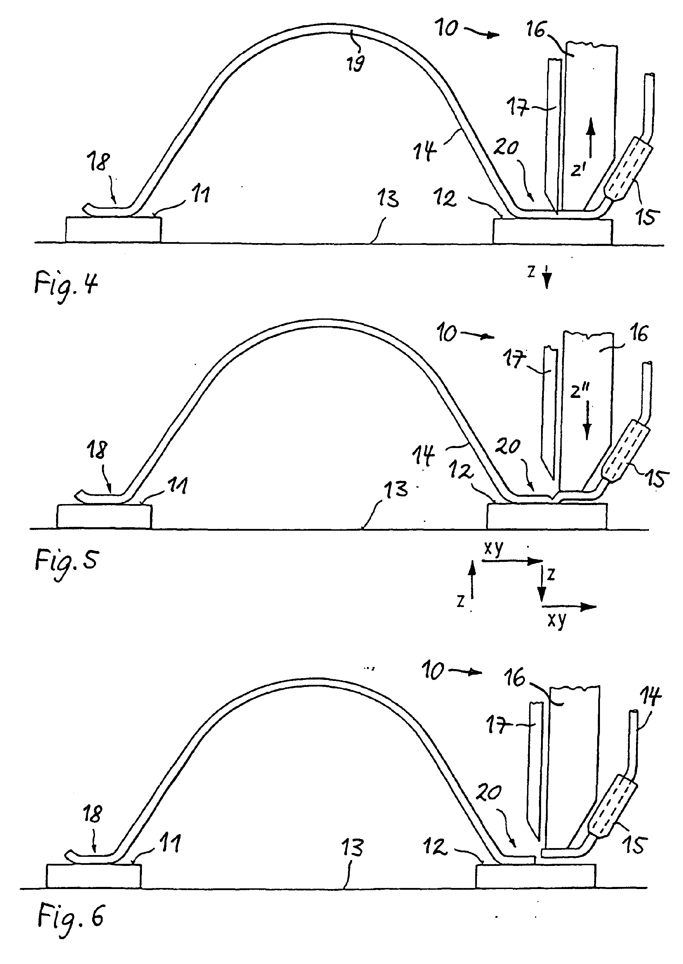

Wie in Fig. 3 dargestellt, wird der Bondkopf mit Stempel, Drahtführungsröhrchen und Messer dann etwas angehoben und in der ursprünglichen Bewegungsrichtung in der xy-Ebene weiter verfahren, was durch die z- und xy-Pfeile unterhalb der zweiten Kontaktfläche 12 symbolisiert ist. Der Bonddraht 14 wird hierbei mitgenommen und hierdurch die sogenannte "Tail-length" 21 erzeugt. Nach Vollendung dieser Bewegung befindet sich das Messer 17 in einer Position seitlich des zweiten Bond 20. Wie in Fig. 4 dargestellt, wird dann der Bondkopf - zusammen mit dem Drahtführungsröhrchen 15 und dem Messer 17 - in dieser laterallen Position gemäß dem z-Pfeil unter der zweiten Kontaktfläche 12 abgesenkt. Gleichzeitig erfolgt eine mit dem Pfeil z' bezeichnete entgegengerichtete Verschiebung des Stempels 16 relativ zum Bondkopf. Im Ergebnis steht nunmehr das Messer 17 mit seiner Schneide sowohl über die Unterseite des Stempels 16 als auch das untere Ende des Drahtführungsröhrchens 15 vor, und das Messer 17 wirkt auf den Bonddraht 14 ein und trennt diesen zumindest teilweise durch.

Gemäß Fig. 5 wird der Bondkopf sodann, wie durch den linken z-Pfeil unter der zweiten Kontaktfläche 12 verdeutlicht, wieder nach oben gefahren, wodurch das Messer 17 wieder aus dem Bonddraht 14 austritt. Dann wird der Stempel 16 - wie durch den z''-Pfeil in seinem Inneren symbolisiert - wieder nach unten verschoben. Anschließend erfolgt eine seitliche Bewegung des Bondkopfes in Richtung des xy-Pfeiles unterhalb der zweiten Kontaktfläche 12, ein erneutes Absenken gemäß dem zweiten z-Pfeil und eine weitere Bewegung in der xy-Ebene, wodurch schließlich der in Fig. 6 dargestellte Zustand erreicht wird, dass der Bonddraht 14 seitlich des zweiten Bonds 20 vollständig durchtrennt ist.

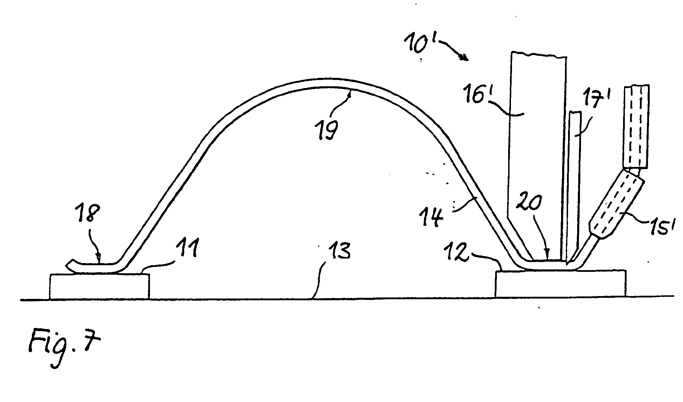

In Fig. 7 ist eine modifizierte Ausführung eines Drahtbonders 10' zusammen mit einer Bonddrahtschlaufe 19 der in Fig. 1 bis 6 gezeigten Art dargestellt. Bei dieser Ausführung befindet sich das Messer 17', in Drahtzuführungsrichtung gesehen, vor dem Stempel 16', d.h. zwischen diesem und dem Drahtzuführungsröhrchen 15'. Das Durchtrennen des Bonddrahtes 14 erfolgt hierbei unmittelbar nach dem zweiten "touch-down" auf der zweiten Kontaktfläche 12, wie in Fig. 7 angedeutet.

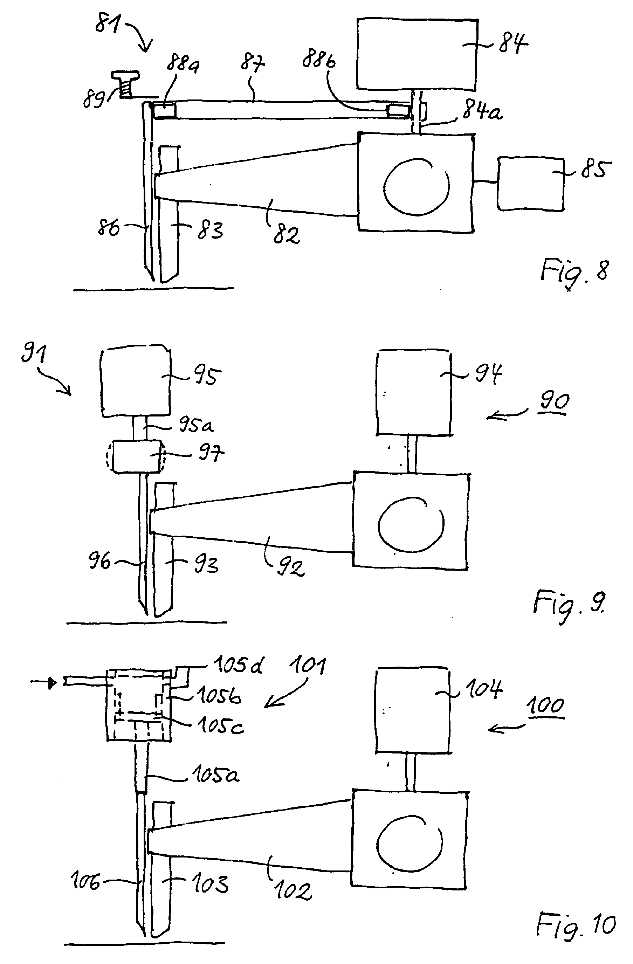

In den Figuren 8 bis 10 sind skizzenartig Ausschnittdarstellungen eines Dickdrahtbonders gezeigt, bei denen Bonddraht-Schneidvorrichtungen 81, 91 bzw. 101 verschiedener Ausführungen jeweils an einem Bondkopf 80, 90 bzw. 100 angebracht sind. Mit Ausnahme der Schneidvorrichtungen haben die Bondköpfe einen übereinstimmenden Aufbau, wobei jeweils ein Ultraschallwandler (Transducer) 82, 92 bzw. 102 mit einem daran angebrachten Bondkeil (Wedge) 83, 93 bzw. 103 in herkömmlicher Bauart vorgesehen ist. Dem Transducer ist jeweils eine Bond-Antriebseinheit 84, 94, bzw. 104 zur Realisierung der vorstehend beschriebenen Auf- bzw. Abwärtsbewegung des Bondkeils zugeordnet.

Bei der Ausführung nach Fig. 8 gibt es eine einzige Antriebseinrichtung 84 mit einer Antriebsstange 84a für Bewegungen der relevanten Werkzeuge - des Bondkeils 83 und eines Messers 86 - in Richtung der Z-Achse. Zu einem zwischenzeitlichen Anheben bzw. Absenken des Bondkeils gemäß dem oben erläuterten Verfahrensablauf (beachte insbesondere Fig. 4 und 5 mit zugehöriger Beschreibung) dient eine gesonderte, insbesondere elektromagnetisch arbeitende, Einrichtung zum Anheben des Transducers ("Transducer-Lift") 85.

Zum Abschneiden des (in diesen Figuren nicht gezeigten) Bonddrahtes ist bei den Ausführungen nach Fig. 9 und 10 eine separate Schneid-Antriebseinrichtung 95 bzw. 105 mit einer Antriebsstange 95a bzw. 105a als Kraftübertragungselement vorgesehen. Bei den Beispielen wird angenommen, dass die Antriebseinrichtung 95 gemäß Fig. 9 ein (nicht näher dargestellter) elektromotorischer Antrieb ist, während die Schneid-Antriebseinrichtung 105 nach Fig. 10 ein Pneumatikantrieb mit einem Pneumatikzylinder 105b und einem zugehörigen Kolben 105c ist. Die Antriebsstange 105a ist zugleich die zugehörige Kolbenstange.

Das Messer 86 der Schneidvorrichtung 81 nach Fig. 8 ist über eine Doppelblattfeder 87 mit endseitig eingepassten Elastomerblöcken 88a, 88b biegeelastisch an der Antriebsstange 84a gehaltert und nahe dem Bondkeil 83 im wesentlichen parallel zu diesem vertikal verschieblich geführt. Durch das Zusammenwirken der Biegeelastizität der Doppelblattfeder 87 und der Formelastizität der Elastomerblöcke 88a, 88b sowie der inneren Reibung dieser Konstruktion wird eine zugleich elastische und gedämpfte Aufhängung des Messers 86 an der Antriebsstange 85a und damit die angestrebte Spitzenkraftbegrenzung beim Schneidvorgang erreicht. Ein höhenverstellbarer Anschlag 89 dient zur Begrenzung der elastischen Auslenkung des Messers 86 beim Auftreffen auf das Substrat auf einen einstellbaren Wert von etwa einem bis zu wenigen Hundertstel Milimetern. Hiermit wird letztlich auch die Dämpfungscharakteristik der Messeraufhängung variiert, die ansonsten durch die Konstruktion und die Materialkonstanten der Doppelblattfeder 87 mit den Elastomerelementen 88a, 88b weitgehend vorgegeben ist.

Bei der Bonddraht-Schneidvorrichtung 91 nach Fig. 9 ist die Schneid-Antriebseinrichtung 95 mit einigem Abstand vom Grundkörper des Bondkopfes 90 derart positioniert, dass die Längsachse der Antriebsstange 95a nahe benachbart zum Bondkeil 93 liegt. Hier erfolgt die gedämpfte, nachgiebige Aufhängung des Messers 96, welches in der Längsachse der Antriebsstange 95a angeordnet ist, über einen zwischen Messer und Antriebsstange angebrachten Elastomerblock 97. Dieser ist sowohl (in begrenztem Umfang) formelastisch als auch kompressibel, und diese Eigenschaften in Verbindung mit der bei einer Verformung auftretenden inneren Reibung bewirken die begrenzt nachgiebige und gedämpfte Aufhängung des Messers und die erfindungsgemäße Spitzenkraftbegrenzung.

Bei der Schneidvorrichtung 101 nach Fig. 10 schließlich ist die Zylinder-Kolben-Einheit 105b/105c der Antriebseinrichtung 105 ebenfalls so angeordnet, dass die Kolbenstange 105a nahe benachbart zum Bondkeil 103 liegt. Das Messer 106 ist hier direkt an der Kolbenstange 105a angebracht, und die angestrebte Spitzenkraftbegrenzung bzw. Dämpfung beim Auftreffen des Messers auf ein Bondsubstrat wird durch ein Überdruckventil 105d am Pneumatikzylinder 105b erreicht, durch den ein beim Auftreffen des Messers auf das Substrat entstehender unzulässig hoher Innendruck im Pneumatikzylinder entweichen kann..

### Bezugszeichenliste

- 10; 10': Drahtbonder
- 11, 12: Kontaktfläche
- 13: Bauelement
- 14: Bonddraht
- 15; 15': Drahtzuführungsröhrchen
- 16; 16': Stempel (Wedge)
- 17; 17': Messer
- 18, 20: Bond
- 19: Bonddrahtschlaue (Loop)
- 21: Tail-length
- 80; 90; 100: Bondkopf
- 81; 91; 101: Bonddraht-Schneidvorrichtung
- 82; 92; 102: Ultraschallwandler (Transducer)
- 83; 93; 103: Bondkeil (Wedge)
- 84; 94; 104: Bond-Antriebseinrichtung
- 84a; 95a; 105a: Antriebsstange
- 85: Transducer-Lift
- 86; 96; 106: Messer
- 87: Doppelblattfeder
- 88a, 88b; 97: Elastomerblock
- 89: Anschlag
- 95; 105: Schneid-Antriebseinrichtung
- 105b: Pneumatikzylinder
- 105c: Kolben
- 105d: Überdruckventil

## Patentansprüche

1. Bonddraht-Schneidvorrichtung (81; 91; 101) zum Abtrennen des über einen Bondkontakt (18, 20) überstehenden Abschnitte eines Bonddrahtes (14) nach Herstellung einer Bondverbindung, mit einem Messer (17; 17'; 86; 96; 106), welches mit einer Bewegungskomponente senkrecht zur Oberfläche eines Substrates (13) und somit des Bondkontaktes bewegbar und
bezüglich der zur Substratoberfläche senkrechten Bewegungskomponente begrenzt nachgiebig gelagert ist derart, dass die auf die Messerschneide bei einem Auftreffen des Messers auf das Substrat einwirkende Kraft auf einen vorbestimmten Spitzenwert begrenzt wird, **dadurch gekennzeichnet, dass**
das Messer (96) über eine druckelastische Lagerung (97) mit einem die senkrechte Bewegungskomponente übertragendenden Kraftübertragungselement (95a) verbunden ist, wobei die druckelastische Lagerung ein formelastisches und/oder kompressibles Elastomerelement (97) aufweist.

2. Bonddraht-Schneidvorrichtung nach Anspruch 1,
**gekennzeichnet durch**
einen die Auslenkung des Messers (17; 17'; 86; 96; 106) begrenzenden Anschlag (89).

3. Bonddraht-Schneidvorrichtung nach Anspruch 2,
**dadurch gekennzeichnet,**
**dass** der Anschlag (89) zur Einstellung der Nachgiebigkeit bzw. des Dämpfungsverhaltens der Halterung des Messers (86) verstellbar ausgeführt ist.

4. Bonddraht-Schneidvorrichtung nach einem der vorangehenden Ansprüche,
**gekennzeichnet durch**
einen gemeinsamen Antrieb (85) für ein Bondwerkzeug (83)und das Messer (86).

5. Bonddraht-Schneidvorrichtung nach einem der vorangehenden Ansprüche,
**dadurch gekennzeichnet, dass**
das Messer (17; 17') nachgiebig an einem Bondkopf eines Drahtbonders (10; 10') angeordnet ist.

6. Verwendung einer Bonddraht-Schneidvorrichtung nach einem der vorangehenden Ansprüche bei einem Drahtbonder.

## Claims

1. Bonding wire cutting device (81; 91; 101) for separating the portion of a bonding wire (14) projecting beyond a bond contact (18, 20) after the establishment of a bond connection, including a blade (17; 17'; 86; 96, 106) being movable with a motion component perpendicular to the surface of a substrate (13) and hence to the bond contact, and being mounted relative to the motion component perpendicular to the substrate surface with limited flexibility such that the force acting upon the blade's cutting edge is limited to a predetermined peak value when the blade impacts the substrate,
**characterized in that** the blade (96) is associated via a pressure-resilient mount (97) to a force-transmitting element (95a) transmitting said perpendicular motion component,
the pressure-resilient mount comprising a form-elastic and/or compressible elastomeric element (97).

2. Bonding wire cutting device in accordance with claim 1,
**characterized by**
a stop (89) limiting the deflection of the blade (17; 17'; 86; 96; 106).

3. Bonding wire cutting device in accordance with claim 2,
**characterized in that**
said stop (89) is realized so as to be adjustable for setting the resilience or the damping behaviour of the blade's (86) mount.

4. Bonding wire cutting device in accordance with any one of the preceding claims,
**characterized by**
a common drive (85) for a bonding tool (83) and said blade (86).

5. Bonding wire cutting device in accordance with any of the preceding claims,
**characterized in that**
said blade (17; 17') is arranged resiliently on a bonding head of a wire bonder (10; 10').

6. Use of a bonding wire cutting device in accordance with any one of the preceding claims in a wire bonder.

## Revendications

1. Dispositif de coupe pour fil de connexion (81 ; 91 ; 101), pour la séparation de la partie, dépassant d'un contact de connexion (18, 20), d'un fil de connexion (14) après la fabrication d'une liaison de connexion, comprenant un couteau (17 ; 17' ; 86 ; 96; 106), qui peut être déplacé avec une composante de mouvement perpendiculairement à la surface d'un substrat (13) et donc du contact de connexion et est monté avec une souplesse limitée par rapport à la composante de mouvement perpendiculaire à la surface du substrat de telle sorte que la force agissant sur la lame de couteau lors d'un impact du couteau sur le substrat est limitée à une valeur maximale prédéfinie, **caractérisé en ce que** le couteau (96) est relié par un support (97) élastique en pression à un élément de transmission de force (95a) transmettant la composante verticale du mouvement, le support élastique en pression présentant un élément élastomère (97), élastique au niveau de la forme et/ou compressible.

2. Dispositif de coupe à fil de connexion selon la revendication 1,
**caractérisé par**
une butée (89) délimitant la déviation du couteau (17 ; 17' ; 86 ; 96 ; 106).

3. Dispositif de coupe à fil de connexion selon la revendication 2,
**caractérisé en ce que**
la butée (89) pour le réglage de la souplesse ou du comportement à l'amortissement du support de couteau (86) est réalisée de façon réglable.

4. Dispositif de coupe à fil de connexion selon l'une quelconque des revendications précédentes, **caractérisé par**
un entraînement (85) commun pour un outil de connexion (83) et le couteau (86).

5. Dispositif de coupe à fil de connexion selon l'une quelconque des revendications précédentes,
**caractérisé en ce que**
le couteau (17 ; 17') est disposé de façon souple sur une tête de connexion d'un dispositif de connexion à fil (10 ; 10').

6. Utilisation d'un dispositif de coupe à fil de connexion selon l'une quelconque des revendications précédentes dans le cas d'un dispositif de connexion à fil.
